# EUROPEAN PATENT APPLICATION

(11) **EP 4 517 958 A1**
(43) Date of publication of application: **05.03.2025**
(21) Application number: 24196581.3
(22) Date of filing: 27.08.2024
(51) Int. Cl.: H01M 50/204, H01M 50/258, H01M 50/262, H01M 50/269, H01M 50/284, H01M 50/296, H01M 50/298

(54) **EXPANDABLE PORTABLE MULTI-FUNCTIONAL ENERGY STORAGE AND POWER SUPPLY DEVICE**

(30) Priority: 29.08.2023 CN 202311099724; 29.08.2023 CN 202322332913 U; 02.02.2024 CN 202420264645 U
(71) Applicant: Guizhou AVEnergy Technology Co., Ltd, Anshun City, Guizhou Province (CN); Guangdong JVEnergy Co., Ltd, Zhaoqing City, Guangdong Province (CN)
(72) Inventor: Qin, Shuyong, Anshun City, Guizhou Province (CN); Luo, Dong, Anshun City, Guizhou Province (CN); Qin, Yan, Anshun City, Guizhou Province (CN); Huang, Zhihua, Anshun City, Guizhou Province (CN)
(74) Representative: Sun, Yiming

(57) **Abstract**

The present disclosure discloses an expandable portable multi-functional energy storage and power supply device, which belongs to new energy storage and application fields. The device includes one or more energy storage and power supply units (100, 01), wherein adjacent energy storage and power supply units are stacked with one on top of another and are electrically connected to each other, the energy storage unit includes a unit main body (1, 011), the unit main body includes one or more module expansion bins (11, 012), a functional module (2, 02) is provided in the module expansion bin, the unit main body is provided with a unit control board (12, 013) at a position corresponding to the module expansion bin, a standard interface terminal is provided on the unit control board, a module control board (021) is provided in the functional module, a standard interface (022) adapted to the standard interface terminal is provided on the module control board, and the standard interface terminal is electrically connected to the standard interface. With respect to the prior art, the energy storage and power supply device has expandability, can integrate different functional modules through a unified standard interface, greatly broaden the scope of application of energy storage products, expand the application scenarios, and make the energy storage and power supply device more portable.

## Description

### Technical Field

The present disclosure belongs to the technical field of new energy storage and application, and particularly relates to an expandable portable multi-functional energy storage and power supply device.

### Background Art

With the progress of science and technology, electronic products are used more and more frequently in daily life; at the same time, more and more traditional products, such as bicycles, automobiles, tea stoves, etc. also use electric energy as a new power source, thus making the use of energy storage and power supply device more and more common.

The existing energy storage and power supply device mostly exists in the form of a charging cabinet, and generally only includes a battery pack, a BMS controller, an inverter module and other structures, taking the mains as an electric energy source to provide a simple power supply function.

For example, the existing patent with the application number CN201920628685.2 discloses a charging cabinet for an outdoor electric vehicle, which is used for charging a battery of the electric vehicle, wherein a plurality of charging grids which can be inserted into a lithium battery of the electric vehicle are supported in a cabinet body of the charging cabinet by a bracket, insulation guide bars in multiple directions are provided at a battery insertion path of an inner cavity of the charging grids for limiting the battery insertion operation; and a limiting sensing button is provided at an end of the battery insertion path, which is deployed in an outdoor environment and can enable a user to conveniently charge the electric vehicle. The charging cabinet disclosed in the above-mentioned patent has a single product form, cannot be expanded and has a limited scope of application.

Based on this, an expandable intelligent charging cabinet appears in the market. For example, the existing patent with the application number CN202121401771.3 discloses a combined expandable multimedia intelligent charging cabinet, including an expansion cabinet body and a control cabinet body, wherein a touch screen and a two-dimensional code scanning module are mounted on a front end of the control cabinet body, a control host, a voice module, a relay and a power supply module are mounted inside the control cabinet body, a threading hole is provided through a side surface of the expansion cabinet body and a waterproof cover is mounted, a plurality of charging bins are provided on the expansion cabinet body, a plug-type micro-switch is mounted on an inner top surface of the charging bin, an electromagnetic lock is mounted on an inner side surface of the charging bin, a front end face of the expansion cabinet body is mounted with a cabinet door via a hinge, a rear end face of the cabinet door is mounted with a locking box, vertical sides of the expansion cabinet body and the control cabinet body are provided with a clamping strip and a clamping groove, and the expansion cabinet body and the control cabinet body can be used by quickly splicing and assembling same into an integrated body with different lengths via a clamping strip, a clamping groove and a connecting bolt, so as to realize the expansion of the intelligent charging cabinet. Although the intelligent charging cabinet disclosed in the patent can achieve the expansion of the cabinet body, the expansion only involves the quantity of charging bins, and the function of the cabinet body cannot be expanded, and it can still only charge the modular battery, which has the disadvantage of single function of the product, and has a very high degree of homogenization with the existing products on the market, which cannot meet the needs of multiple-scenario applications of users.

### Summary of the Invention

In order to solve the above-mentioned problems, the primary object of the present disclosure is to provide an expandable portable multi-functional energy storage and power supply device, which has expandability, can integrate different functional modules through a unified standard interface, greatly broaden the scope of application of energy storage products, expand the application scenarios, and make the energy storage and power supply device more portable;
another object of the present disclosure is to provide an expandable portable multi-functional energy storage and power supply device that can be used as a power supply base with unlimited expansion of applications.

To achieve the above-mentioned object, the present disclosure adopts the following technical solution:
the present disclosure provides an expandable portable multi-functional energy storage and power supply device, including one or more energy storage and power supply units, wherein adjacent energy storage and power supply units are stacked with one on top of another and are electrically connected to each other, the energy storage unit includes a unit main body, the unit main body includes one or more module expansion bins, a functional module is provided in the module expansion bin, the unit main body is provided with a unit control board at a position corresponding to the module expansion bin, a standard interface terminal is provided on the unit control board, a module control board is provided in the functional module, a standard interface adapted to the standard interface terminal is provided on the module control board, and the standard interface terminal is electrically connected to the standard interface. In the present application, functional modules such as a battery module, an adapter module and an inverter module can be mounted in the module expansion bin, a unified standard interface terminal is provided in the module expansion bin, the standard interface adapted to the standard interface terminal only needs to be provided on the control board of each functional module, and each functional module is electrically connected to the unit main body by means of the standard interface being adapted and plugged into the standard interface terminal, so that the device has a multi-functional effect, without external connection to devices such as a mains power supply and an inverter, and is more portable to use. Secondly, the energy storage and power supply unit of the present application can be provided with multiple layers, and the series-parallel connection between the energy storage and power supply units of various layers is realized by means of stacking, which has expandability, and the quantity of energy storage and power supply units can be set according to specific application scenarios.

Further, the functional module includes a battery module, an adapter module and an inverter module. In the present application, the battery module can supply power to the energy storage and power supply device, the adapter module can adapt to a plurality of different jacks, and the inverter module can convert alternating current and use different devices to be powered.

Further, the standard interface terminal includes a Type-C terminal, the standard interface includes a Type-C interface, and the electrical connection between the energy storage and power supply unit and the functional module is realized in a Type-C connection manner, so that the power supply of the functional module can be realized and the transmission of data can also be performed.

Further, the unit control board and the module control board both adopt a PCB board.

Further, a first anti-dead terminal group and a second anti-dead terminal group are provided on the unit control board, the first anti-dead terminal group and the second anti-dead terminal group are respectively symmetrically provided on a left side and a right side of the standard interface terminal, a first anti-dead jack group and a second anti-dead jack group corresponding to positions of the first anti-dead terminal group and the second anti-dead terminal group are provided on the module control board, and the first anti-dead terminal group and the second anti-dead jack group are respectively symmetrically provided on a left side and a right side of the standard interface. In the present application, the anti-dead jack group adapted to the anti-dead terminal group is provided on the functional module to realize an electrical connection between the functional module and the unit main body, and the anti-dead terminal groups and the anti-dead jack groups are provided as two groups of symmetrical structures, which can realize normal power supply of positive and negative connections and have an anti-dead effect.

Further, the first anti-dead terminal group and the second anti-dead terminal group each include an even number of anti-dead connection sheets, the first anti-dead jack group and the second anti-dead jack group each include an even number of anti-dead jacks, adjacent anti-dead connection sheets form a group of positive and negative pole connections, and adjacent anti-dead jacks form a group of positive and negative pole connections; and a user can realize normal positive and negative electrode connections of a module during forward and reverse insertions, and has an anti-dead effect for positive and negative electrodes.

Further, the energy storage and power supply unit further includes a front locking shell, the front locking shell is connected to a front end of the module expansion bin, a front end of the functional module is provided with a locking portion, and the locking portion is movably clamped with the front locking shell. In the present application, by performing a movable clamping connection between the locking portion and the front locking shell, not only the fixing between the functional module and the module expansion bin can be achieved, but also the disassembly of the functional module and convenient assembly can be achieved.

The front locking shell is provided with an opening communicating with the module expansion bin, the front locking shell is provided with a clamping groove on a side wall located at the opening, the locking portion includes a locking main body, a movable buckle, a return spring and a toggle piece, the locking main body is provided with a movable groove therein, the movable buckle and the return spring are both provided in the movable groove, a front end of the movable buckle penetrates through a side wall of the movable groove and is movably clamped in the clamping groove, one end of the return spring abuts against an end of the movable buckle, the other end thereof is supported on the side wall, away from the clamping groove, of the movable groove, the toggle piece is rotatably connected to the locking main body, and the toggle piece is able to drive the movable buckle to move in the movable groove toward the return spring by rotation, so that the front end of the movable buckle retracts into the movable groove. In the present application, when the functional module is mounted in the module expansion bin, the movable buckle is clamped in the clamping groove to achieve the locking between the two. When it is necessary to disassemble and assemble the functional module, it is only necessary to pull the toggle piece, driving the toggle piece to rotate on the locking main body, forcing the movable buckle to move towards the return spring, the front end of the movable buckle retracts into the movable groove, and the movable buckle does not snap into the clamping groove, so that the disassembly and assembly of the functional module can be achieved; when the disassembly and assembly of the functional module is completed, the toggle piece is released, the movable buckle is reset under the action of the return spring, and the front end of the movable buckle can be clamped with the clamping groove to achieve locking.

A rotary shaft is provided on an outer side surface of the locking main body, the toggle piece is rotatably connected to the locking main body via the rotary shaft, a via hole is further provided on the outer side surface of the locking main body, a first toggle baffle is provided on an inner side of the toggle piece, a second toggle baffle is further provided on an outer side of the movable buckle, and the first toggle baffle passes through the via hole and abuts against the second toggle baffle. When the toggle piece is toggled, the first toggle baffle pushes the second toggle baffle to move, so that the movable buckle moves in the movable groove.

The outer side surface of the locking main body is further provided with a limiting protrusion protruding outwards, the toggle piece is provided with a toggle sheet connected to the first toggle baffle, the toggle sheet is provided with a limiting groove, and a front end of the limiting protrusion is limited in the limiting groove. In normal use, the toggle sheet can be limited and fixed.

In the present application, the clamping connection between the front locking shell and the locking portion can also be made in the following manner: the front locking shell is provided with an elastic buckle on a side wall located at the opening, the locking portion includes a locking main body, the locking main body is provided with a clamping groove, and the elastic buckle is movably clamped in the clamping groove; the locking portion further includes a rotary handle and a sliding block, the locking main body is provided with a sliding groove, the sliding groove is provided below the clamping groove, and the sliding groove is in communication with the clamping groove; the sliding block is slidably connected in the sliding groove, and a top of the sliding block is separably connected to the elastic buckle; and the rotary handle is provided with a rotary portion, a side wall of the rotary portion is provided with a spiral sliding protrusion, the sliding block is provided with a spiral groove adapted to the sliding protrusion, the rotary portion is horizontally and rotatably connected to the locking main body, and the sliding protrusion is slidably connected in the spiral groove. In the present application, when the rotary handle is rotated horizontally, the spiral sliding protrusion can move relative to the spiral groove. Since the rotary handle and the locking portion are only connected in a horizontal rotation and are fixed in an up-and-down direction, the rotary handle does not move up and down when rotating horizontally, the sliding protrusion will force the sliding block to move up and down in the sliding groove, and a top of the sliding block will disengage or bear against the elastic buckle; when the top of the sliding block abuts against the elastic buckle, the elastic buckle will be pushed out of the clamping groove, so as to achieve the unlocking between the locking portion and the front locking shell; and when the top of the sliding block is separated from the elastic buckle, the elastic buckle is reset into the clamping groove based on its own elasticity to achieve locking between the locking portion and the front locking shell.

Further, a conductive post assembly is further provided in the energy storage and power supply unit, the conductive post assembly is electrically connected to the unit control board, and an upper end and a lower end of the conductive post assembly extend outside the energy storage and power supply unit. In the present application, the energy storage and power supply units stacked on one another up and down are electrically connected via the conductive post assembly to realize the power supply connection of all the energy storage and power supply units.

The conductive post assembly includes a conductive post main body, an upper movable buckle, an upper ejection spring and a lower adjustment spring, wherein the energy storage and power supply unit is further provided with a columnar groove penetrating up and down therein, a groove is provided on an outside of a top side wall of the columnar groove, a protrusion adapted to the groove is provided on an outside of a bottom side wall of the columnar groove, the upper movable buckle is movably provided in the groove, and a through hole communicating with the columnar groove is provided in both the upper movable buckle and the protrusion, the conductive post main body is provided in the columnar groove, and the upper end and the lower end of the conductive post main body respectively penetrate into the through holes of the protrusion and the upper movable buckle, a middle portion of the conductive post main body protrudes to a peripheral side to form a wiring connection post, the upper ejection spring is provided on an upper portion of the conductive post main body, an upper end of the upper ejection spring abuts against a bottom of the upper movable buckle, a lower end of the upper ejection spring abuts against an upper top surface of the wiring connection post, the lower adjustment spring is sheathed on a lower portion of the conductive post main body, an upper end of the lower adjustment spring abuts against a lower bottom surface of the wiring connection post, and a lower end of the lower adjustment spring abuts against a lower bottom surface of the columnar groove. In the present application, when the energy storage and power supply units are provided in a stacked manner, the protrusion at the bottom of the upper energy storage and power supply unit is opposite to the groove at the top of the lower energy storage and power supply unit, a layer of the upper energy storage and power supply unit is pressed down on the basis of self-weight, and the protrusion of the lower conductive post assembly presses the upper movable buckle of the lower conductive post assembly to move downward in the groove thereof, so that the top of the conductive post main body of the lower energy storage and power supply unit is exposed, and can bear against the bottom of the conductive post main body of the upper energy storage and power supply unit, achieving close contact and maintaining the stability of the connection between the upper energy storage and power supply unit and the lower energy storage and power supply unit. At the same time, when the upper conductive post main body and the lower conductive post main body abut against each other, both the upper and lower conductive post main bodies generate relative displacement in the columnar groove due to the pressure, and at this time, the lower adjustment spring can adjust the position of the conductive post main body by its own elastic force to avoid excessive displacement; in addition, the upper ejection spring is compressed when stacked, and the lower upper movable buckle can be reset by the elastic force of the upper ejection spring when the upper energy storage and power supply unit is removed.

The conductive post assembly further includes a limiting buckle, a limiting clamping groove is provided on the wiring connection post, a limiting mounting groove is provided on a side wall of the columnar groove, two sides of the limiting buckle are fixed in the limiting mounting groove, and a middle portion of the limiting buckle is clamped in the limiting clamping groove and is able to move up and down in the limiting clamping groove. When the conductive post main body moves up and down within a certain range, the limiting buckle can always be clamped in the limiting clamping groove, and can limit the up and down movement of the conductive post main body, so as to prevent the conductive post main body from falling out of the columnar groove.

The energy storage and power supply unit further includes a rear shell, the conductive post assemblies are provided in four groups, the rear shell and the front locking shell are both provided with two columnar grooves in parallel from left to right, the two columnar grooves on the front locking shell are located directly in front of the two columnar grooves on the rear shell, the four groups of conductive post assemblies are respectively provided in the four columnar grooves, two first connecting flexible wires are provided in the unit main body, two second connecting flexible wires are further provided in the rear shell, a front end of the first connecting flexible wire is electrically connected to the conductive post main body in the front locking shell, a rear end of the first connecting flexible wire is connected to a first electrical connection block, the first electrical connection block is electrically connected to the unit control board, a rear end of the second connecting flexible wire is electrically connected to the conductive post main body in the rear shell, a front end of the second connecting flexible wire is connected to a second electrical connection block, and the second electrical connection block is electrically connected to the unit control board. In the present application, a cross electrical connection among each module expansion bin in the energy storage and power supply unit and an electrical connection between adjacent energy storage and power supply units are realized by four groups of conductive post assemblies. Secondly, the energy storage and power supply unit of the present application can also be used outdoors as a power supply base, and only four docking connection ends with the conductive post assemblies need to be provided at a bottom of products such as an electric tea stove, an electric oven, a wireless charging platform, an electromagnetic oven, an outdoor fan, an outdoor refrigerator, an outdoor coffee maker, outdoor lighting, a power-assisted bicycle, an unmanned aerial vehicle and an electric tool, so that the electrical connection with the energy storage and power supply unit can be realized, and the application scenario of the product can be effectively expanded.

The rear end of the first connecting flexible wire is further sheathed with a first locking ring, a first locking screw is threaded on the first locking ring, and the first electrical connection block and the rear end of the first connecting flexible wire are both provided in the first locking ring and are locked by the first locking screw. The rear end of the second connecting flexible wire is further sheathed with a second locking ring, a second locking screw is threaded on the second locking ring, and the second electrical connection block and the rear end of the second connecting flexible wire are both provided in the second locking ring and are locked by the second locking screw. In the present application, both the first connecting flexible wire and the second connecting flexible wire use a flexible copper wire, which can move. One end of the copper wire is fixed by a locking screw, and the conductive post main body connected at the other end can move up and down by using a bending property of the flexible copper wire, and has a certain stroke movement, so as to facilitate achieving close contact between the upper conductive post main body and the lower conductive post main body.

A top of the energy storage and power supply unit is further provided with a power generation control module, wherein the power generation control module includes a housing and an electric control assembly, the electric control assembly is provided in the housing, the electric control assembly includes a power generation control board, an electrical connection sheet and a power generation connection post, the power generation connection posts are provided in four, the housing is provided with four connection holes corresponding to positions of the conductive post assemblies of the energy storage and power supply unit, and the four power generation connection posts are respectively mounted in the four connection holes to be electrically connected to the conductive post assemblies, the electrical connection sheets are provided in two, four power generation connection posts are cross-connected via two electrical connection sheets, the electrical connection sheets are electrically connected to the power generation control board, and the power generation control board is further provided with a standard power supply interface with one end exposed. In the present application, the power generation control module can be connected to an external wind power generation device and a solar power generation device via the standard power supply interface to achieve power generation control, and then is electrically connected to the energy storage and power supply unit via four power generation connection posts to store electric energy into the battery module. It needs to be stated that the control principle of the power generation control module in the present application is a conventional technology for controlling wind power generation and solar power generation, and falls within the prior art, and the specific implementation method does not need to be disclosed in the present application.

The housing includes an upper shell and a lower shell, and the power generation connection post includes a threaded connection post. The threaded connection post can realize both the electrical connection between the power generation control module and the energy storage and power supply unit and the fixing between the upper shell and the lower shell.

In the present application, each energy storage and power supply unit can also be electrically connected in the following manner: the energy storage and power supply unit includes a unit conductive connection sheet, the unit conductive connection sheet penetrates the rear shell up and down, the unit conductive connection sheet is electrically connected to the unit control board, one end of the unit conductive connection sheet is provided with a clamping portion, the other end thereof is provided with a clamping groove, and the clamping portion is adapted to the clamping groove. In the present application, when the energy storage and power supply units of the upper and lower layers are stacked, conductive connection can be performed via the unit conductive connection sheet, and when connected, the unit conductive connection sheets of the upper and lower layers can be clamped and fixed via the clamping groove and the clamping portion, so as to ensure the stability of the conductive connection.

A first limiting protrusion is provided on a bottom of the rear shell, a first limiting groove is provided on a top of the rear shell, the first limiting protrusion is adapted to be clamped with the first limiting groove, a top of the unit conductive connection sheet is provided in the first limiting groove, and a bottom of the unit conductive connection sheet is provided in the first limiting protrusion. When the energy storage and power supply units of the upper and lower layers are stacked, the first limiting protrusion can cooperate with the first limiting groove to ensure the stability of the unit conductive connection sheet.

A second limiting protrusion is provided on a bottom of the front locking shell, a second limiting groove is provided on a top of the front locking shell, and the second limiting protrusion is adapted to be clamped with the second limiting groove. When the energy storage and power supply units of the upper and lower layers are stacked, the second limiting protrusion can cooperate with the second limiting groove for limiting positions to ensure the stability of the structure.

A penetration hole is provided on the front locking shell or the rear shell, a positioning rod is provided in the penetration hole, the positioning rod penetrates the penetration hole up and down, a threaded connection end is provided at a bottom of the positioning rod, an internal thread adapted to the threaded connection end is provided at a top of the positioning rod, and the threaded connection end is in threaded connection with the internal thread. When the energy storage and power supply units of the upper and lower layers are stacked, the positioning rods of the upper and lower layers can achieve fixation between the energy storage and power supply units of the upper and lower layers by means of a threaded connection fitting of the threaded connection end and the internal thread.

A knurled nut is also fixed in the penetration hole, and a middle portion of the positioning rod is in threaded connection with the knurled nut. When positioning rods of the upper and lower layers are threadedly connected, the knurled nut can ensure the fixing of the positioning rod of the lower layer and facilitate the screwing of the positioning rod of the upper layer to achieve the threaded connection between the positioning rods of the upper and lower layers.

Further, a heat dissipation fan is further provided behind the module expansion bin, the heat dissipation fan is electrically connected to the unit control board, the heat dissipation fan is provided in the rear shell, and a heat dissipation vent hole is further provided on the rear shell.

Compared to the prior art, advantages of the present disclosure are listed as follows.
1. By setting a standardized interface, the function of the product can be expanded in a modular way, the changeable and differentiated forms of the product can be increased, and the application scenarios of the product can be expanded;
2. Each functional module adopts a buckle structure for mounting and dismounting, while the structure is simple and convenient for dismounting;
3. The energy storage and power supply units of the product are in series-parallel connection in the form of conductive copper posts, simplifying the traditional terminal connection method, and facilitating the stack expansion of the energy storage and power supply units; and
4. The forward and reverse connections between the functional module and the energy storage and power supply unit are designed to be more convenient for electrical connection.

### Brief Description of the Drawings

Figure 1 is an axonometric drawing of embodiment 1.
Figure 2 is a schematic structural diagram of an individual energy storage and power supply unit according to embodiment 1.
Figure 3 is a schematic structural diagram of a battery module according to embodiment 1.
Figure 4 is a schematic structural diagram of a rear shell of the energy storage and power supply unit according to embodiment 1.
Figure 5 is a schematic structural diagram of a front locking shell of the energy storage and power supply unit according to embodiment 1.
Figure 6 is a schematic structural diagram of the energy storage and power supply unit according to embodiment 1 with a unit main body hidden.
Figure 7 is a schematic structural diagram of four groups of conductive post assemblies according to embodiment 1.
Figure 8 is a partially enlarged diagram at A in figure 7.
Figure 9 is a schematic structural diagram of a locking portion according to embodiment 1.
Figure 10 is an exploded diagram of the locking portion according to embodiment 1.
Figure 11 is a top view of two energy storage and power supply units according to embodiment 1 after being stacked.
Figure 12 is a cross-sectional diagram at A-A in figure 11.
Figure 13 is a partially enlarged diagram at B in figure 12.
Figure 14 is a side view of the individual energy storage and power supply unit according to embodiment 1.
Figure 15 is a cross-sectional diagram at A-A in figure 14.
Figure 16 is a partially enlarged diagram at C in figure 15.
Figure 17 is an exploded diagram of a power generation control module according to embodiment 1.
Figure 18 is a principle diagram of a circuit of the energy storage and power supply unit according to embodiment 1.
Figure 19 is a partially enlarged diagram at D in figure 18.
Figure 20 is a partially enlarged diagram at E in figure 18.
Figure 21 is a partially enlarged diagram at F in figure 18.
Figure 22 is a partially enlarged diagram at H in figure 18.
Figure 23 is an axonometric drawing of embodiment 2.
Figure 24 is a schematic structural diagram of an energy storage and power supply unit according to embodiment 2 from a first perspective.
Figure 25 is a partially enlarged diagram at A in figure 24.
Figure 26 is a schematic structural diagram of the energy storage and power supply unit according to embodiment 2 from a second perspective.
Figure 27 is a schematic structural diagram of the energy storage and power supply unit according to embodiment 2 with a front locking shell, a unit main body and a rear shell hidden.
Figure 28 is a schematic structural diagram of a unit conductive connection sheet according to embodiment 2.
Figure 29 is a schematic structural diagram of a functional module according to embodiment 2 from a first perspective.
Figure 30 is a schematic structural diagram of the functional module according to embodiment 2 from a second perspective.
Figure 31 is a schematic structural diagram of a locking portion according to embodiment 2.
Figure 32 is a schematic structural diagram of a sliding block according to embodiment 2.
Figure 33 is a schematic structural diagram of a rotary handle according to embodiment 2.
Figure 34 is a front view of embodiment 2.
Figure 35 is a cross-sectional diagram at A-A in figure 34.
Figure 36 is a partially enlarged diagram at B in figure 35.
Figure 37 is a cross-sectional diagram at B-B in figure 34.
Figure 38 is a partially enlarged diagram at C in figure 37.

In the drawings:
100, energy storage and power supply unit, 1, unit main body, 2, battery module, 3, adapter module, 4, inverter module, 5, module backplate, 6, front locking shell, 7, locking portion, 8, conductive post assembly, 9, columnar groove, 40, heat dissipation fan.
11, module expansion bin, 12, unit control board, 13, Type-C terminal, 14, anti-dead connection sheet.
51, Type-C interface, 52, anti-dead jack, 61, opening, 62, clamping groove, 71, locking main body, 72, movable buckle, 73, return spring, 74, toggle piece, 711, movable groove, 75, rotary shaft, 712, via hole, 741, first toggle baffle, 742, toggle sheet, 743, limiting groove, 721, second toggle baffle, 76, limiting protrusion.
81, conductive post main body, 82, upper movable buckle, 83, upper ejection spring, 84, lower adjustment spring, 85, wiring connection post, 86, limiting buckle, 851, limiting clamping groove, 91, groove, 92, protrusion, 93, through hole.
10, rear shell, 101, heat dissipation vent hole, 20, second flexible copper wire, 201, first electrical connection block, 202, first locking ring, 203, first locking screw, 30, first flexible copper wire, 301, second electrical connection block, 302, second locking ring, 303, second locking screw.
50, power generation control module, 501, upper shell, 502, lower shell, 503, power generation control board, 504, electrical connection sheet, 505, threaded connection post, 506, connection hole, 507, standard power supply interface.
01, energy storage and power supply unit, 011, unit main body, 012, module expansion bin, 013, unit control board, 014, penetration hole, 015, front locking shell, 0151, opening, 0152, elastic buckle, 0153, second limiting protrusion, 0154, second limiting groove, 0155, knurled nut, 016, rear shell, 0161, first limiting protrusion, 0162, first limiting groove, 0163, heat dissipation vent hole, 017, unit conductive connection sheet, 0171, clamping portion, 0172, clamping groove, 018, positioning rod, 0181, threaded connection end, 0182, internal thread, 019, heat dissipation fan.
02, functional module, 021, module control board, 022, standard interface, 023, locking portion, 0231, locking main body, 0232, clamping groove, 0233, rotary handle, 0234, sliding block, 0235, sliding groove, 0236, rotary portion, 0237, sliding protrusion, 0238, spiral groove.

### Detailed Description of the Invention

In order that the objects, technical solutions and advantages of the present disclosure may be more clearly understood, the present disclosure will be described in further detail below in combination with the accompanying drawings and the embodiments. It should be understood that the particular embodiments described herein are illustrative only and are not restrictive.

To achieve the above-mentioned object, the present embodiment adopts the following technical solution:

### Embodiment 1:

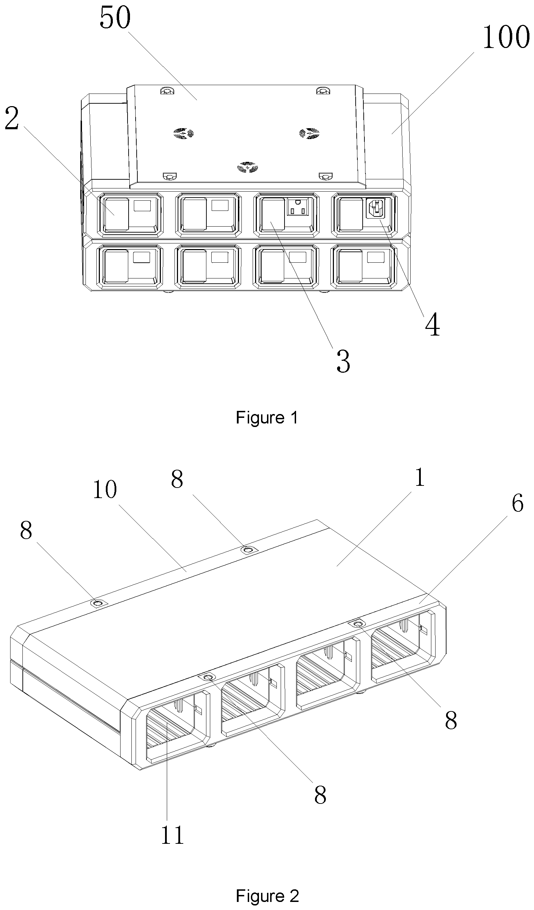

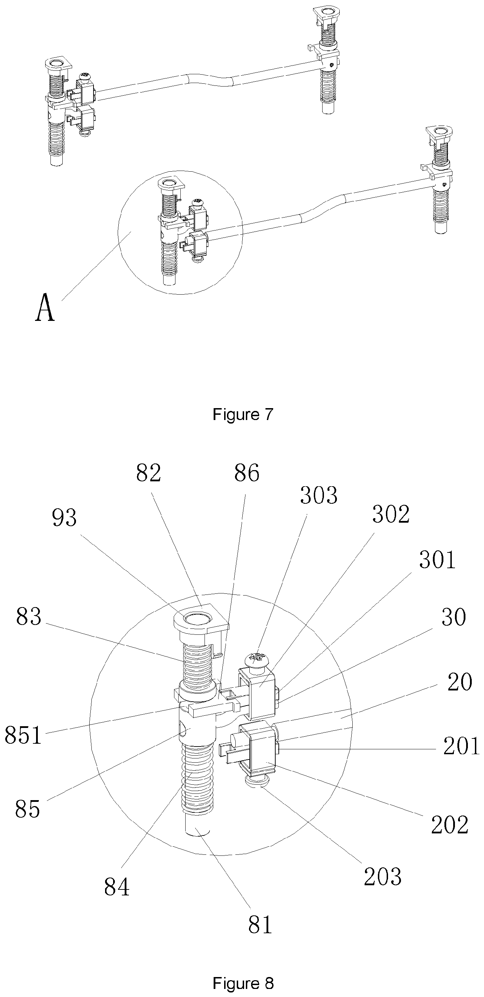

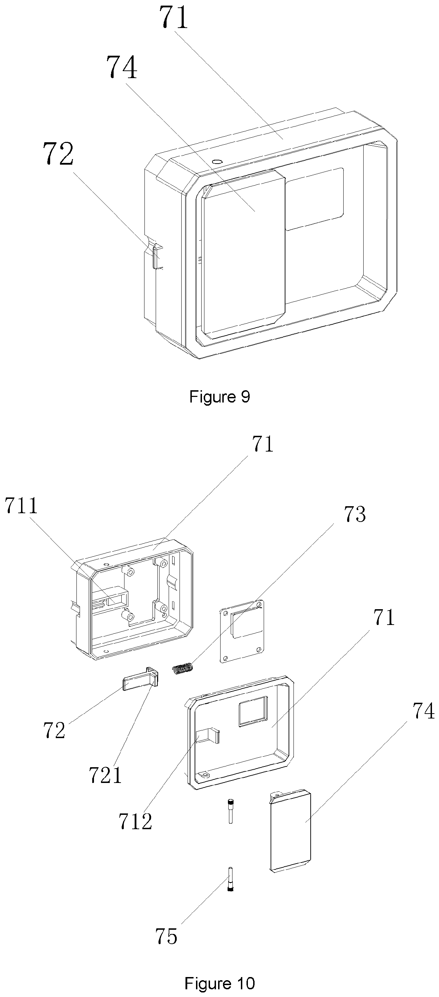

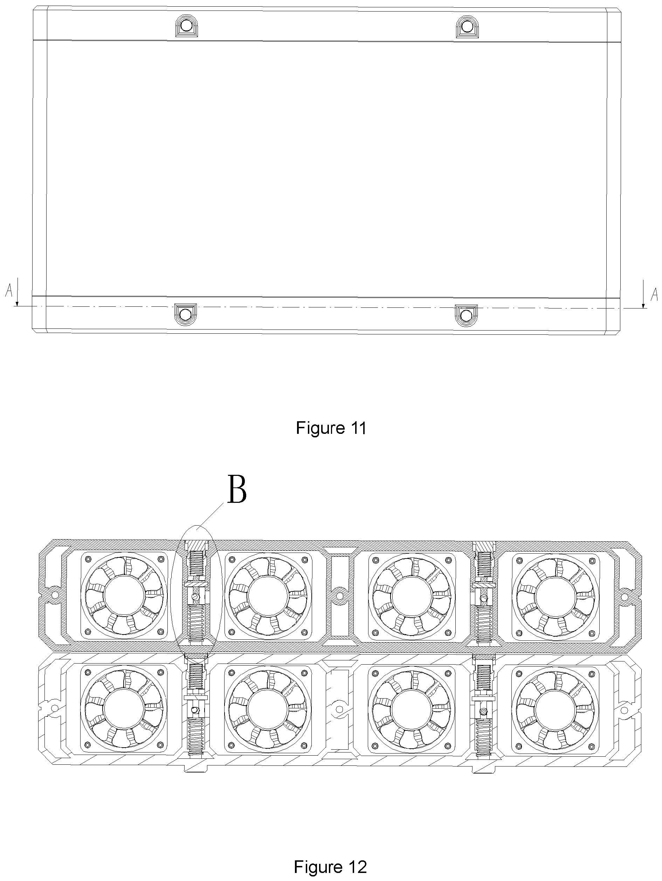

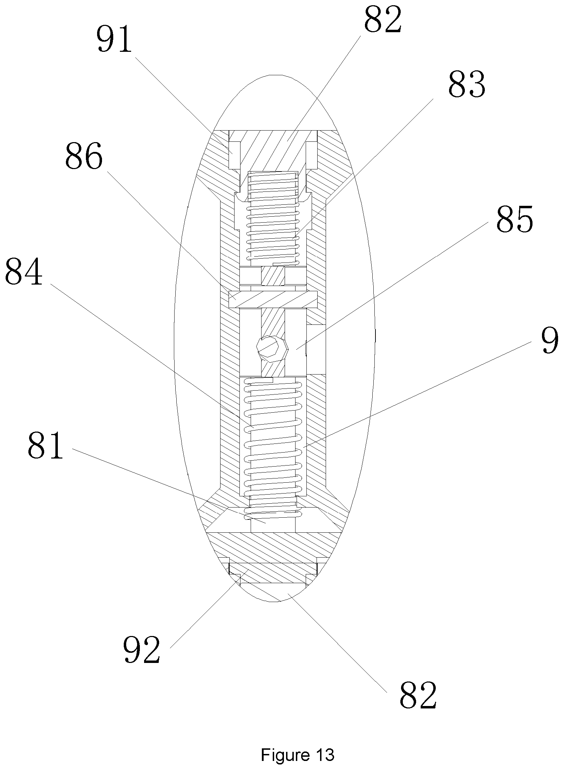

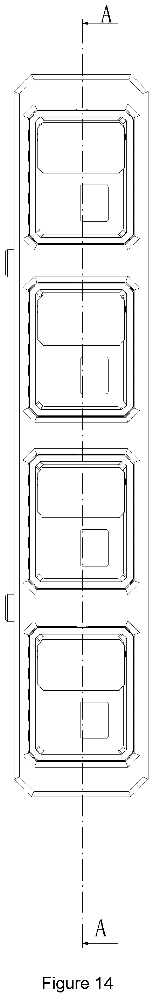

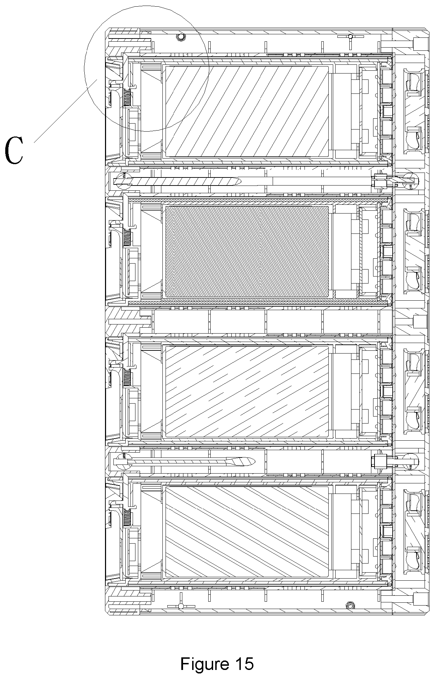

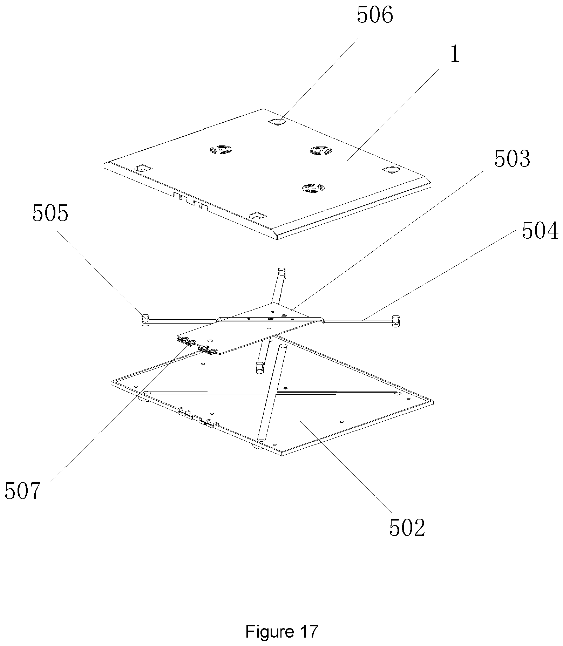

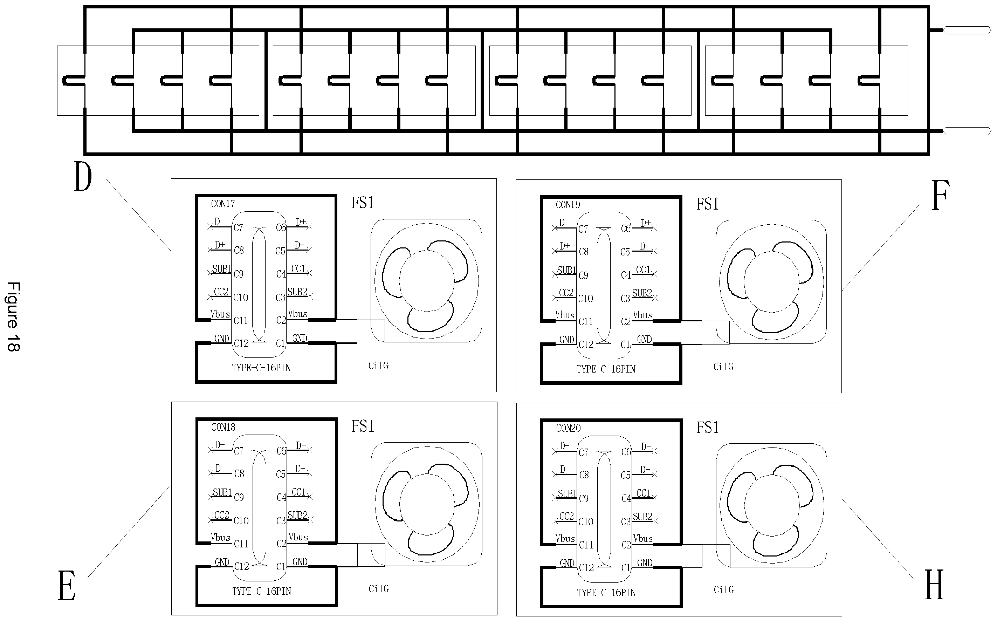

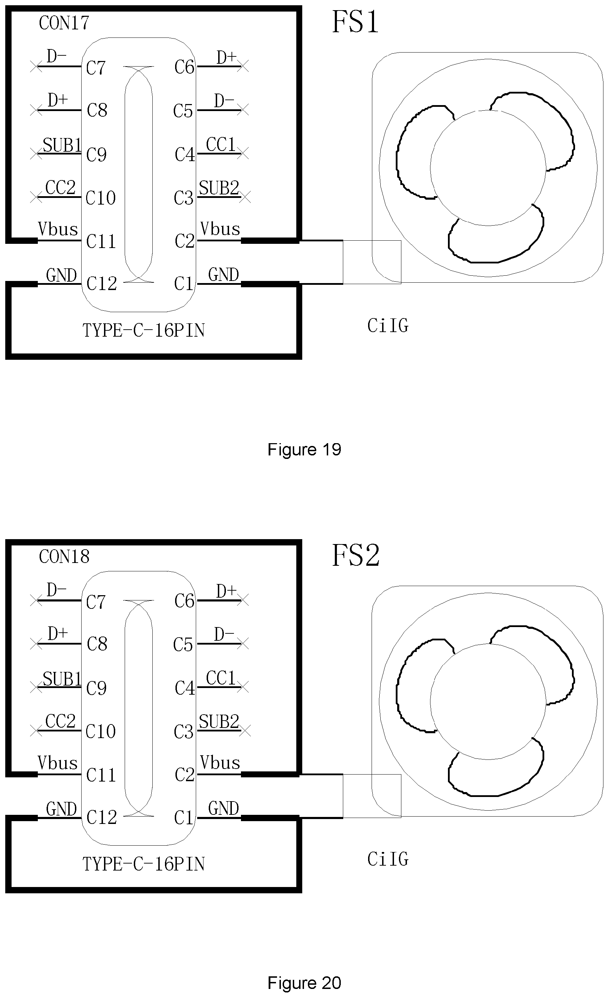

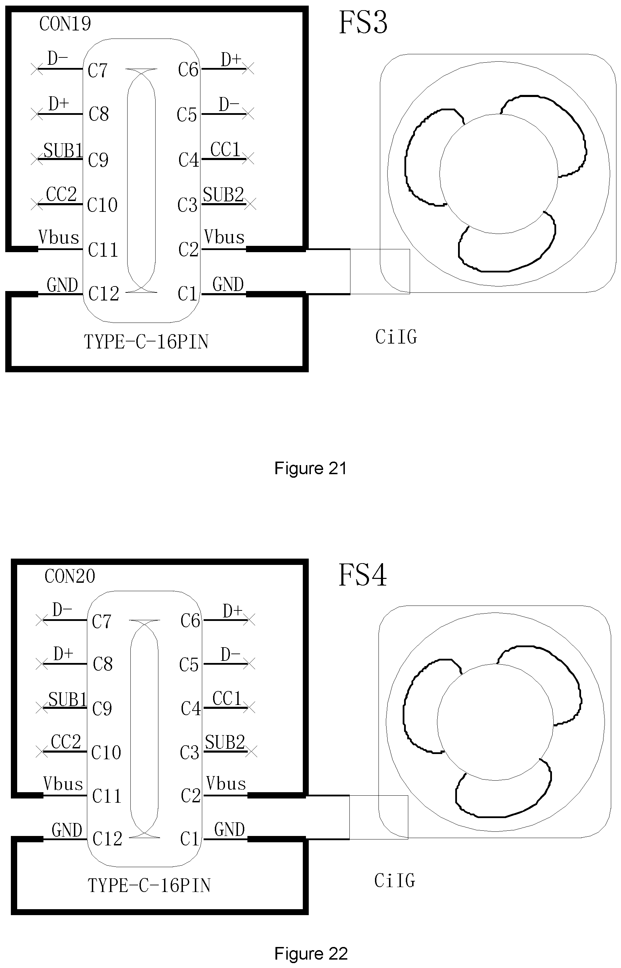

With reference to figures 1-22, the present embodiment provides an expandable portable multi-functional energy storage and power supply device, including one or more energy storage and power supply units 100, wherein adjacent energy storage and power supply units 100 are stacked with one on top of another and are electrically connected to each other, the energy storage unit includes a unit main body 1, the unit main body 1 includes one or more module expansion bins 11, a battery module 2, an adapter module 3 and an inverter module 4 are provided in the module expansion bin 11, the unit main body 1 is provided with a unit control board 12 at a position corresponding to the module expansion bin 11, a Type-C terminal 13 is provided on the unit control board 12, a module backplate 5 is provided in the battery module 2, the adapter module 3 and the inverter module 4, the module control board is provided on an inner side of the module backplate 5, a Type-C interface 51 adapted to the Type-C terminal 13 is provided on the module backplate 5, the Type-C interface 51 is connected to the module control board, and the Type-C terminal 13 is electrically connected to the Type-C interface 51. In the present application, functional modules such as the battery module 2, the adapter module 3 and the inverter module 4 can be mounted in the module expansion bin 11, the battery module 2 can supply power to the energy storage and power supply device, the adapter module 3 can adapt to a plurality of different jacks, and the inverter module 4 can convert alternating current and use different devices to be powered. A unified Type-C terminal 13 is provided in the module expansion bin 11, the Type-C interface 51 only needs to be provided on the control board of each functional module, and each functional module is electrically connected to the unit main body 1 through the adaptation and plug-in of the Type-C terminal 13 and the Type-C interface 51 so as to realize the power supply and data transmission of each functional module, so that the device has a multi-functional effect, without external mains power supply, inverters and other devices, and is more portable to use. Secondly, the energy storage and power supply unit 100 of the present application can be provided with multiple layers, and the series-parallel connection between the energy storage and power supply units 100 of various layers is realized by means of stacking, which has expandability, and the quantity of energy storage and power supply units 100 can be set according to specific application scenarios.

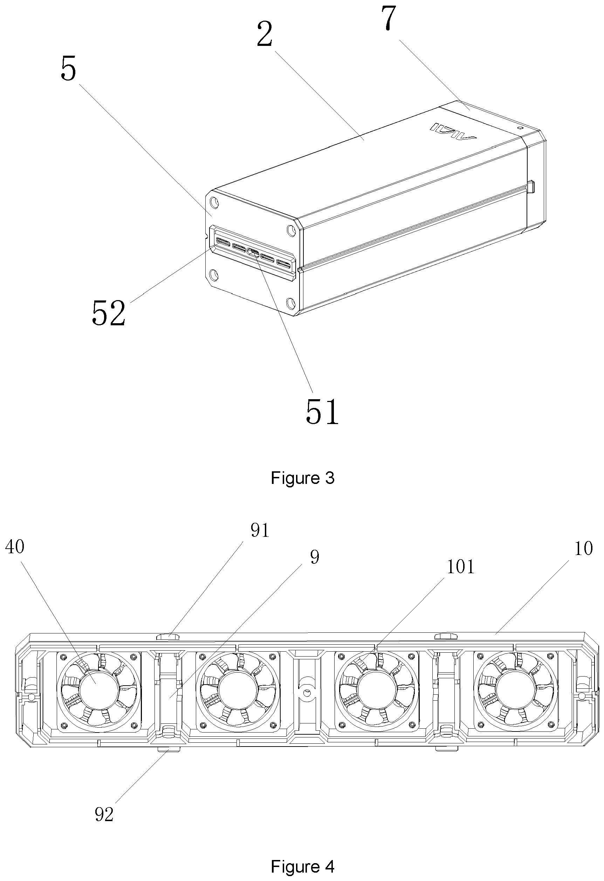

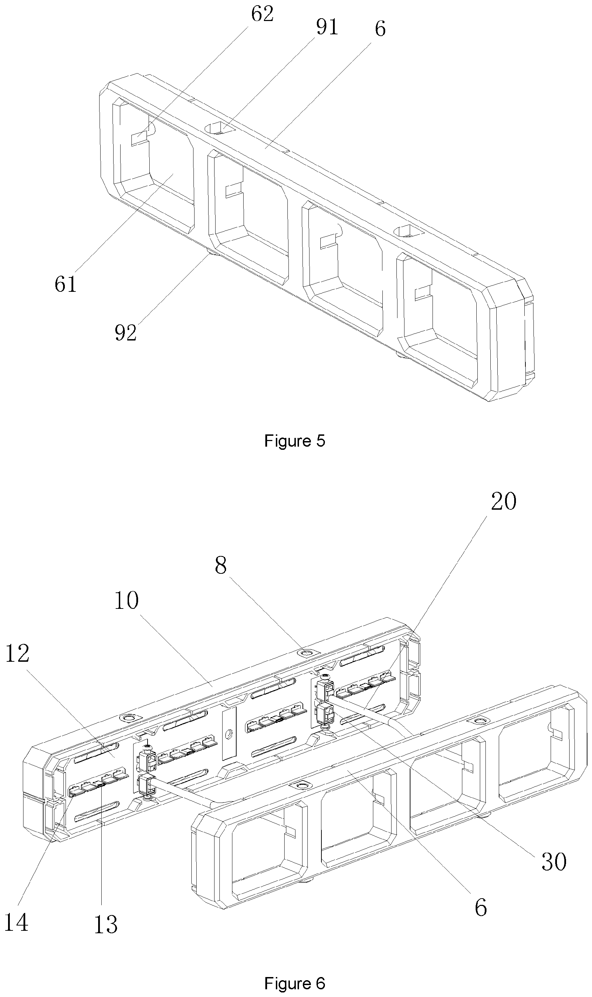

With reference to figures 3 and 6, the unit control board 12 is respectively provided with two anti-dead connection sheets 14 on a left side and a right side of the Type-C terminal 13, the two anti-dead connection sheets 14 on the left side are symmetrical to the two anti-dead connection sheets 14 on the right side, the two anti-dead connection sheets 14 on the left side form a group of positive and negative pole connections, and the two anti-dead connection sheets 14 on the right side form a group of positive and negative pole connections. Two anti-dead jacks 52 are respectively provided on a left side and a right side of the Type-C interface 51 on the module backplate 5, the anti-dead jacks 52 are connected to the module control board, the two anti-dead jacks 52 on the left side are symmetrical to the two anti-dead jacks 52 on the right side, the two anti-dead jacks 52 on the left side form a group of positive and negative pole connections, and the two anti-dead jacks 52 on the right side form a group of positive and negative pole connections. The user can realize the normal positive and negative electrical connections of the module during forward and reverse insertions, which has an anti-dead effect on the positive and negative poles.

With reference to figures 1-6, the energy storage and power supply unit 100 further includes a front locking shell 6, wherein the front locking shell 6 is connected to a front end of the module expansion bin 11, front ends of the battery module 2, the adapter module 3 and the inverter module 4 are provided with a locking portion 7, and the locking portion is movably clamped with the front locking shell 6. In the present application, by performing a movable clamping connection between the locking portion 7 and the front locking shell 6, not only the fixing between the functional module and the module expansion bin 11 can be achieved, but also the disassembly of each functional module and convenient assembly can be achieved.

With reference to figures 1-6, 9 and 10, the front locking shell 6 is provided with an opening 61 communicating with the module expansion bin 11, the front locking shell 6 is provided with a clamping groove 62 on a side wall located at the opening 61, the locking portion 7 includes a locking main body 71, a movable buckle 72, a return spring 73 and a toggle piece 74, the locking main body 71 is provided with a movable groove 711 therein, the movable buckle 72 and the return spring 73 are both provided in the movable groove 711, a front end of the movable buckle 72 penetrates through a side wall of the movable groove 711 and is movably clamped in the clamping groove 62, one end of the return spring 73 abuts against an end of the movable buckle 72, the other end thereof is supported on the side wall, away from the clamping groove 62, of the movable groove 711, the toggle piece 74 is rotatably connected to the locking main body 71, and the toggle piece 74 is able to drive the movable buckle 72 to move in the movable groove 711 toward the return spring 73 by rotation, so that the front end of the movable buckle 72 retracts into the movable groove 711. In the present application, when the functional module is mounted in the module expansion bin 11, the movable buckle 72 is clamped in the clamping groove 62 to achieve the locking between the two. When it is necessary to disassemble and assemble the functional module, it is only necessary to pull the toggle piece 74, driving the toggle piece 74 to rotate on the locking main body 71, forcing the movable buckle to move towards the return spring 73, the front end of the movable buckle 72 retracts into the movable groove 711, and the movable buckle 72 does not snap into the clamping groove 62, so that the disassembly and assembly of the functional module can be achieved; when the disassembly and assembly of the functional module is completed, the toggle piece 74 is released, the movable buckle 72 is reset under the action of the return spring 73, and the front end of the movable buckle 72 can be clamped with the clamping groove 62 to achieve locking.

Further, a rotary shaft 75 is provided on an outer side surface of the locking main body 71, the toggle piece 74 is rotatably connected to the locking main body 71 via the rotary shaft 75, a via hole 712 is further provided on the outer side surface of the locking main body 71, a first toggle baffle 741 is connected on an inner side of the toggle piece 74, a second toggle baffle 721 is further connected on an outer side of the movable buckle 72, and the first toggle baffle 741 passes through the via hole 712 and abuts against the second toggle baffle 721. When the toggle piece 74 is toggled, the first toggle baffle 741 pushes the second toggle baffle 721 to move, so that the movable buckle 72 moves in the movable groove 711.

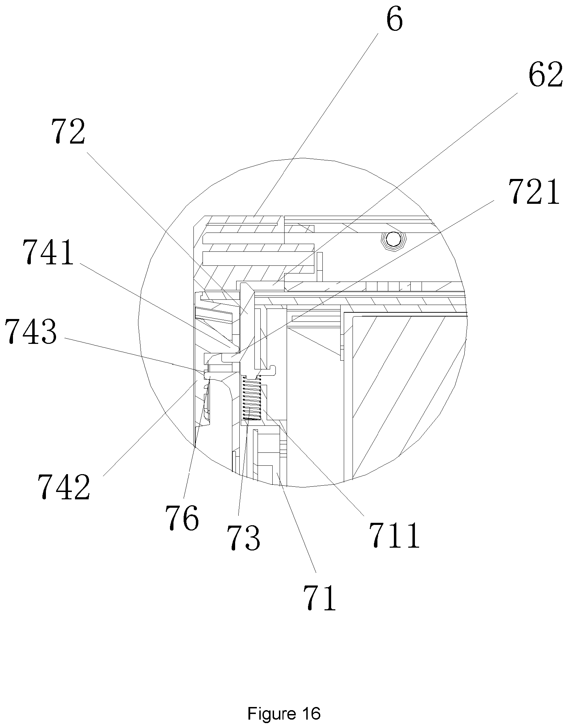

With reference to figure 16, the outer side surface of the locking main body 71 is further connected with a limiting protrusion 76 protruding outwards, the toggle piece 74 is provided with a toggle sheet 742 connected to the first toggle baffle 741, the toggle sheet 742 is provided with a limiting groove 743, and a front end of the limiting protrusion 76 is limited in the limiting groove 743. In normal use, the toggle sheet 742 can be limited and fixed.

Referring to figures 1-8, a conductive post assembly 8 is further provided in the energy storage and power supply unit 100, the conductive post assembly 8 is electrically connected to the unit control board 12, and an upper end and a lower end of the conductive post assembly 8 extend outside the energy storage and power supply unit 100. In the present application, the energy storage and power supply units 100 stacked on one another up and down are electrically connected via the conductive post assembly 8 to realize the power supply connection of all the energy storage and power supply units 100.

With reference to figures 6, 8 and 13, the conductive post assembly 8 includes a conductive post main body 81, an upper movable buckle 82, an upper ejection spring 83 and a lower adjustment spring 84, wherein the energy storage and power supply unit 100 is further provided with a columnar groove 9 penetrating up and down therein, a groove 91 is provided on an outside of a top side wall of the columnar groove 9, a protrusion 92 adapted to the groove 91 is provided on an outside of a bottom side wall of the columnar groove 9, the upper movable buckle 82 is movably provided in the groove 91, and a through hole 93 communicating with the columnar groove 9 is provided in both the upper movable buckle 82 and the protrusion 92, the conductive post main body 81 is provided in the columnar groove 9, and the upper end and the lower end of the conductive post main body 81 respectively penetrate into the through holes 93 of the protrusion 92 and the upper movable buckle 82, a middle portion of the conductive post main body 81 protrudes to a peripheral side to form a wiring connection post 85, the upper ejection spring 83 is provided on an upper portion of the conductive post main body 81, an upper end of the upper ejection spring 83 abuts against a bottom of the upper movable buckle 82, a lower end of the upper ejection spring abuts against an upper top surface of the wiring connection post 85, the lower adjustment spring 84 is sheathed on a lower portion of the conductive post main body 81, an upper end of the lower adjustment spring 84 abuts against a lower bottom surface of the wiring connection post 85, and a lower end of the lower adjustment spring 84 abuts against a lower bottom surface of the columnar groove 9. In the present application, when the energy storage and power supply units 100 are provided in a stacked manner, the protrusion 92 at the bottom of the upper energy storage and power supply unit 100 is opposite to the groove 91 at the top of the lower energy storage and power supply unit 100, a layer of the upper energy storage and power supply unit 100 is pressed down on the basis of self-weight, and the protrusion 92 of the lower conductive post assembly 8 presses the upper movable buckle 82 of the lower conductive post assembly 8 to move downward in the groove 91 thereof, so that the top of the conductive post main body 81 of the lower energy storage and power supply unit 100 is exposed, and can bear against the bottom of the conductive post main body 81 of the upper energy storage and power supply unit 100, achieving close contact and maintaining the stability of the connection between the upper energy storage and power supply unit 100 and the lower energy storage and power supply unit 100. At the same time, when the upper conductive post main body 81 and the lower conductive post main body 81 abut against each other, both the upper and lower conductive post main bodies 81 generate relative displacement in the columnar groove 9 due to the pressure, and at this time, the lower adjustment spring 84 can adjust the position of the conductive post main body 81 by its own elastic force to avoid excessive displacement; in addition, the upper ejection spring is compressed when stacked, and the lower upper movable buckle 82 can be reset by the elastic force of the upper ejection spring when the upper energy storage and power supply unit 100 is removed.

Further, the conductive post assembly 8 further includes a limiting buckle 86, a limiting clamping groove 851 is provided on the wiring connection post 85, a limiting mounting groove 94 is provided on a side wall of the columnar groove 9, two sides of the limiting buckle 86 are fixed in the limiting mounting groove 94, and a middle portion of the limiting buckle 86 is clamped in the limiting clamping groove 851 and is able to move up and down in the limiting clamping groove 851. When the conductive post main body 81 moves up and down within a certain range, the limiting buckle 86 can always be clamped in the limiting clamping groove 851, and can limit the up and down movement of the conductive post main body 81, so as to prevent the conductive post main body 81 from falling out of the columnar groove 9.

Further, the energy storage and power supply unit 100 further includes a rear shell 10, the conductive post assemblies 8 are provided in four groups, the rear shell 10 and the front locking shell 6 are both provided with two columnar grooves 9 in parallel from left to right, the two columnar grooves 9 on the front locking shell 6 are located directly in front of the two columnar grooves 9 on the rear shell 10, the four groups of conductive post assemblies 8 are respectively provided in the four columnar grooves 9, two first flexible copper wires 20 are provided in the unit main body 1, two second flexible copper wires 30 are further provided in the rear shell 10, a front end of the first flexible copper wire 20 is electrically connected to the conductive post main body 81 in the front locking shell 6, a rear end of the first flexible copper wire 20 is connected to a first electrical connection block 201, the first electrical connection block 201 is electrically connected to the unit control board 12, a rear end of the second flexible copper wire 30 is electrically connected to the conductive post main body 81 in the rear shell 10, a front end of the second flexible copper wire 30 is connected to a second electrical connection block 301, and the second electrical connection block 301 is electrically connected to the unit control board 12. In the present application, a cross electrical connection among each module expansion bin 11 in the energy storage and power supply unit 100 and an electrical connection between adjacent energy storage and power supply units 100 are realized by four groups of conductive post assemblies 8. Secondly, the energy storage and power supply unit 100 of the present application can also be used outdoors as a power supply base, and only four docking connection ends with the conductive post assemblies 8 need to be provided at a bottom of products such as an electric tea stove, an electric oven, a wireless charging platform, an electromagnetic oven, an outdoor fan, an outdoor refrigerator, an outdoor coffee maker, outdoor lighting, a power-assisted bicycle, an unmanned aerial vehicle and an electric tool, so that the electrical connection with the energy storage and power supply unit 100 can be realized, and the application scenario of the product can be effectively expanded.

Further, the rear end of the first flexible copper wire 20 is further sheathed with a first locking ring 202, a first locking screw 203 is threaded on the first locking ring 202, and the first electrical connection block 201 and the rear end of the first flexible copper wire 20 are both provided in the first locking ring 202 and are locked by the first locking screw 203. The rear end of the second flexible copper wire 30 is further sheathed with a second locking ring 302, a second locking screw 303 is threaded on the second locking ring 302, and the second electrical connection block 301 and the rear end of the second flexible copper wire 30 are both provided in the second locking ring 302 and are locked by the second locking screw 303. In the present application, both the first flexible copper wire 20 and the second flexible copper wire 30 use a flexible copper wire, which can move. One end of the flexible copper wire is fixed by a locking screw, and the conductive post main body 81 connected at the other end can move up and down by using a bending property of the flexible copper wire, and has a certain stroke movement, so as to facilitate achieving close contact between the upper conductive post main body 81 and the lower conductive post main body 81.

Further, a heat dissipation fan 40 is further provided behind the module expansion bin 11, the heat dissipation fan 40 is electrically connected to the unit control board 12, the heat dissipation fan 40 is provided in the rear shell 10, and a heat dissipation vent hole 101 is further provided on the rear shell 10.

Further, the top of the energy storage and power supply unit 100 is further provided with a power generation control module 50, wherein the power generation control module 50 includes an upper shell 501, a lower shell 502, a power generation control board 503, an electrical connection sheet 504 and a threaded connection post, the upper shell 501 and the lower shell 502 are detachably and fixedly connected via the threaded connection post 505, the power generation control board 503, the electrical connection sheet 504 and the threaded connection post 505 are provided in an accommodating cavity formed by the combination of the upper shell 501 and the lower shell 502, the threaded connection posts 505 are provided in four, the upper shell 501 and the lower shell 502 are each provided with four connection holes 506 corresponding to positions of the conductive post assemblies 8 of the energy storage and power supply unit 100, four threaded connection posts 505 are respectively mounted in the four connection holes 506 to be electrically connected to the conductive post assemblies 8, the electrical connection sheets 504 are provided in two, the four threaded connection posts 505 are cross-connected via the two electrical connection sheets 504, the electrical connection sheets 504 are electrically connected to the power generation control board 503, and the power generation control board 503 is further provided with a standard power supply interface 507 with one end exposed. In the present application, the power generation control module 50 can be connected to an external wind power generation device and a solar power generation device via the standard power supply interface to achieve power generation control, and then is electrically connected to the energy storage and power supply unit 100 via four threaded connection posts 505 to store electric energy into the battery module 2. The threaded connection post 505 can realize both the electrical connection between the power generation control module 50 and the energy storage and power supply unit 100 and the fixing between the upper shell 501 and the lower shell 502.

It needs to be stated that the control principle of the power generation control module 50 in the present embodiment is a conventional technology for controlling wind power generation and solar power generation, and falls within the prior art, and the specific implementation method does not need to be disclosed in the present application.

### Embodiment 2:

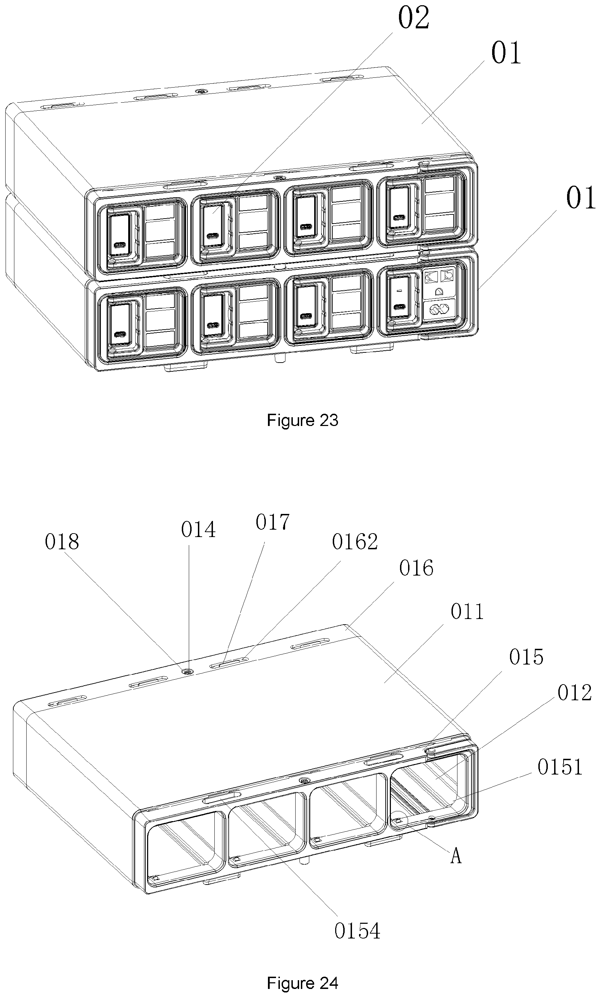

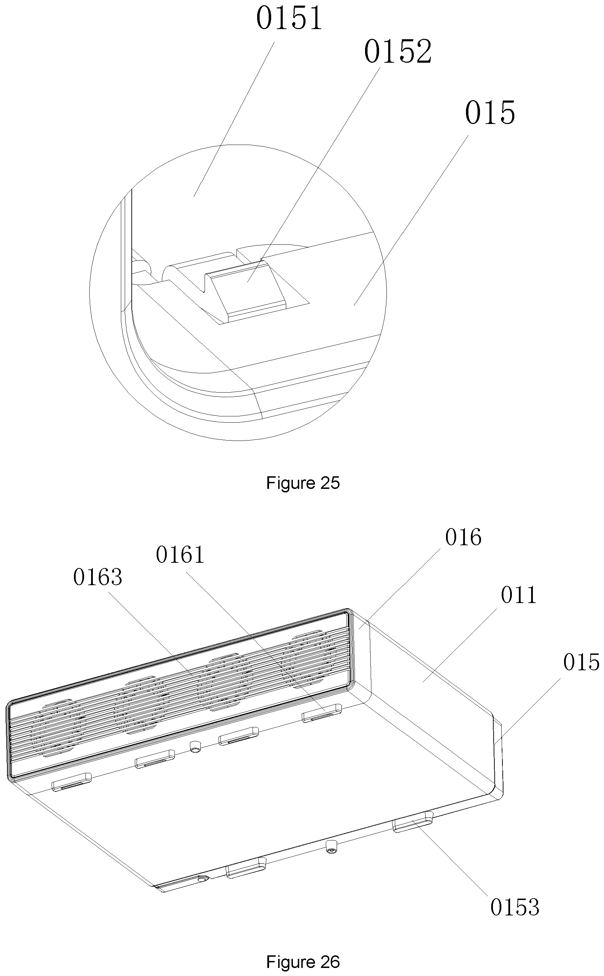

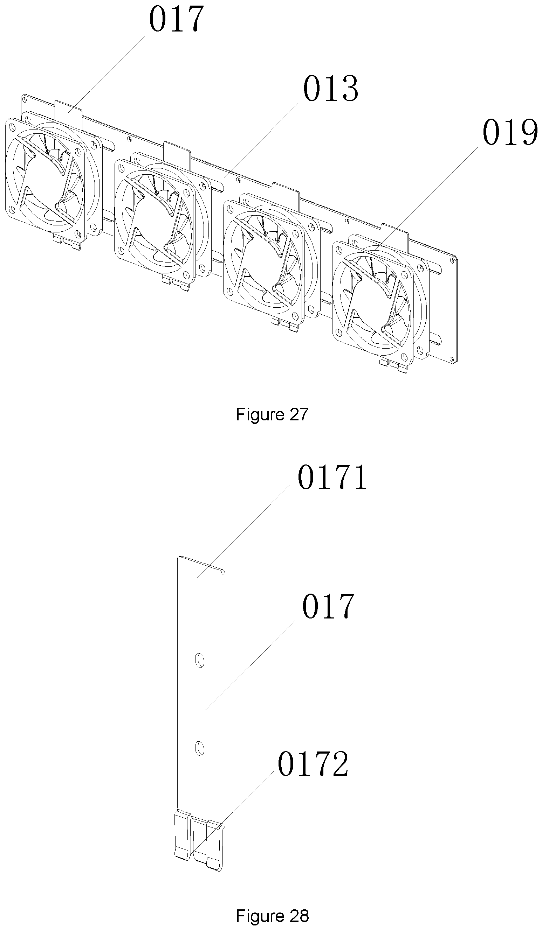

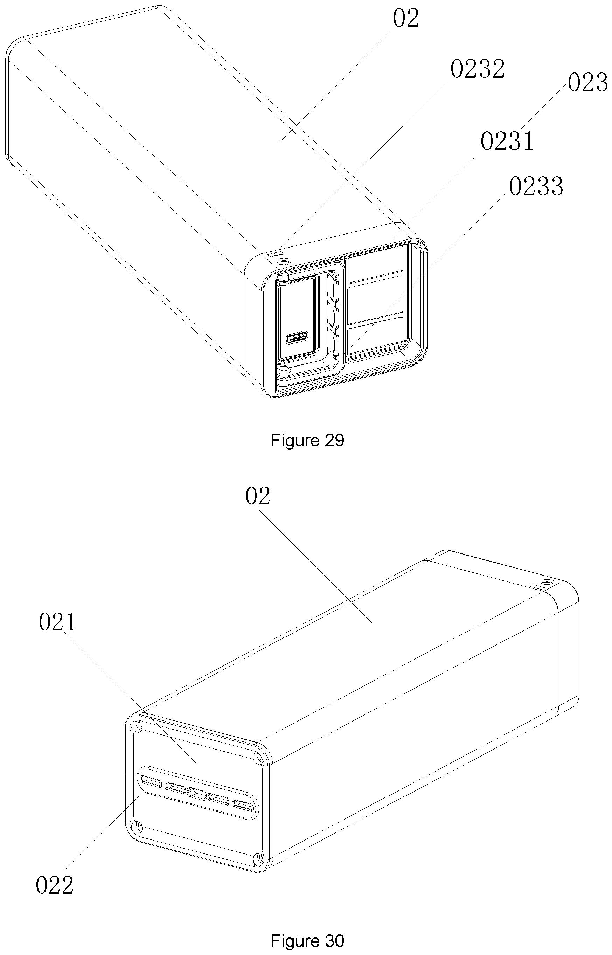

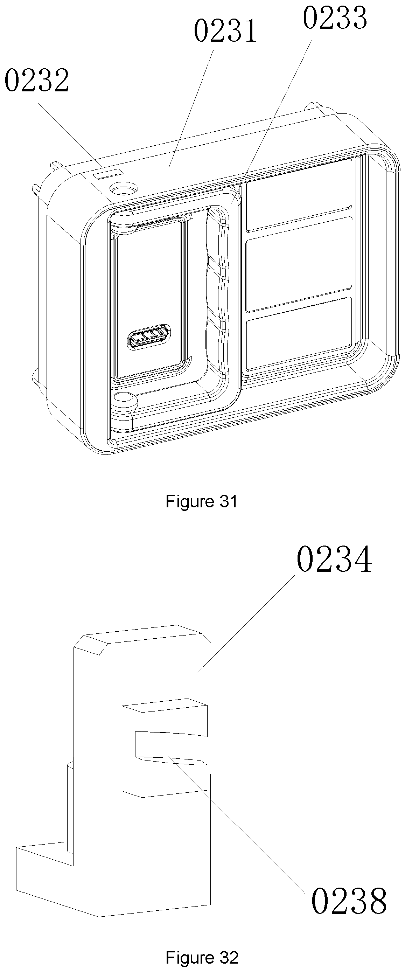

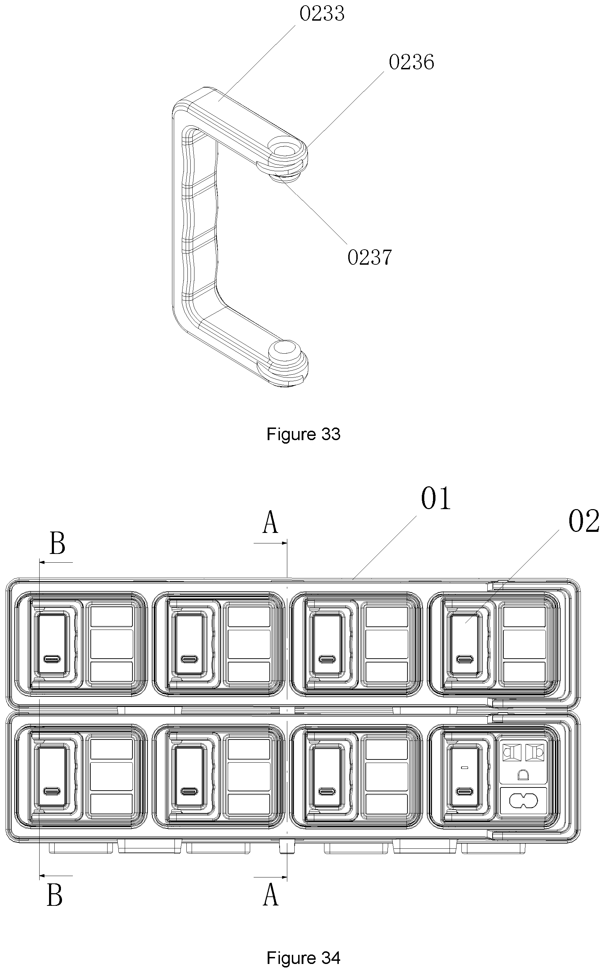

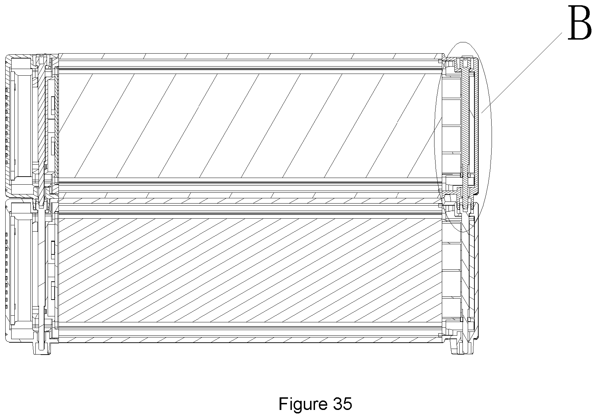

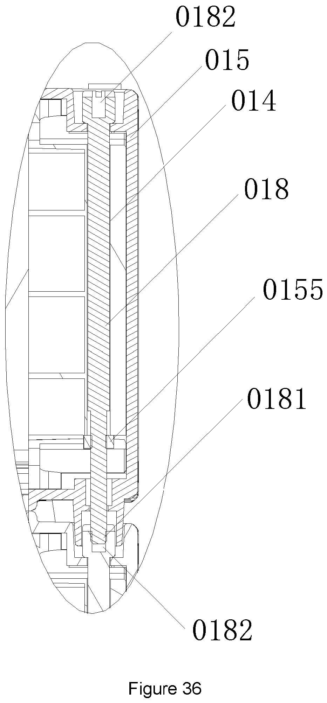

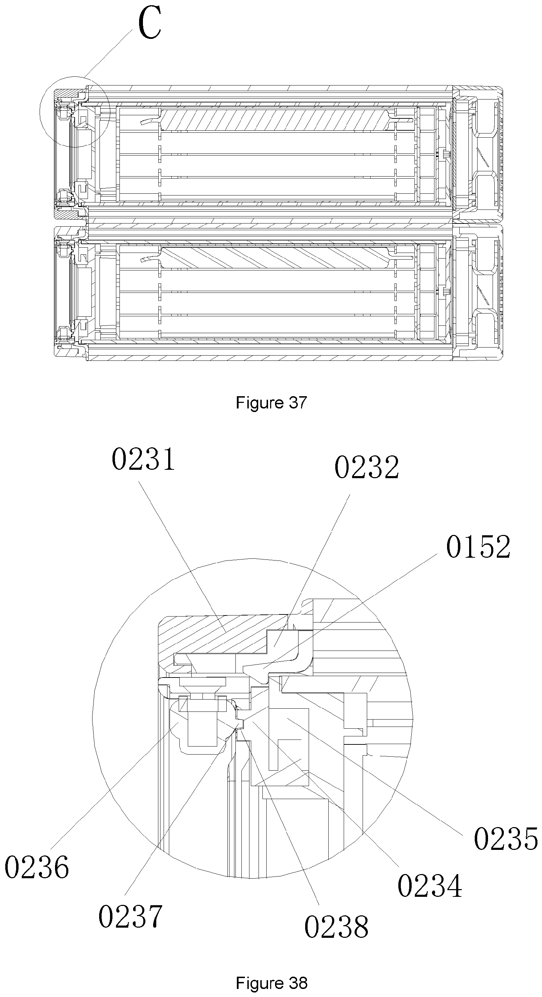

With reference to figures 23-38, an expandable portable multi-functional energy storage and power supply device includes: two or more energy storage and power supply units 01, wherein the two energy storage and power supply units 01 are stacked with one on top of another and are electrically connected to each other, the energy storage and power supply unit 01 includes a unit main body 011, the unit main body 011 is provided with four module expansion bins 012, the module expansion bin 012 is provided with a functional module 02, the unit main body 011 is provided with a unit control board 013 at a position corresponding to the module expansion bin 012, the unit control board 013 is provided with a standard interface terminal (not shown), the functional module 02 is provided with a module control board 021, and the module control board 021 is provided with a standard interface 022 adapted to a standard interface terminal (not shown) electrically connected to the standard interface 022.

In this embodiment, the functional module 02 uses modules such as a battery module, an adapter module and an inverter module. The battery module can supply power to the energy storage and power supply device, the adapter module can adapt to a plurality of different jacks, and the inverter module can convert alternating current and conveniently use different devices to be powered. A unified standard interface terminal (not shown) is provided in the module expansion bin 012, the standard interface 022 adapted to the standard interface terminal (not shown) only needs to be provided on the control board of each functional module 02, and each functional module 02 is electrically connected to the unit main body 011 by means of the standard interface 022 being adapted and plugged into the standard interface terminal (not shown), so that the device has a multi-functional effect, without external connection to devices such as a mains power supply and an inverter, and is more portable to use. Secondly, the energy storage and power supply unit 01 of the present application can be provided with multiple layers, and the series-parallel connection between the energy storage and power supply units 01 of various layers is realized by means of stacking, which has expandability, and the quantity of energy storage and power supply units 01 can be set according to specific application scenarios.

In the present embodiment, the unit control board 013 and the module control board 021 both adopt a PCB board.

In the present embodiment, the standard interface terminal (not shown) adopts a Type-C terminal, the standard interface adopts a Type-C interface, and the electrical connection between the energy storage and power supply unit 01 and the functional module 02 is realized in a Type-C connection manner, so that the power supply of the functional module 02 can be realized and the transmission of data can also be performed.

It needs to be stated that the battery module, the inverter module and the adapter module in the present application are all modularized products, and fall within the prior art, and it is also common knowledge to connect same with other electronic devices by means of Type-C to achieve an extended function, hence the specific circuit structure and circuit principle thereof are not further explained in the present application.

Further, the energy storage and power supply unit 01 further includes a front locking shell 015, the front locking shell 015 is connected to a front end of the module expansion bin 012, a front end of the functional module 02 is provided with a locking portion 023, and the locking portion 023 is movably clamped with the front locking shell 015. In the present application, by performing a movable clamping connection between the locking portion 023 and the front locking shell 015, not only the fixing between the functional module 2 and the module expansion bin 012 can be achieved, but also the disassembly of each functional module 02 and convenient assembly can be achieved.

Further, the front locking shell 015 is provided with an opening 0151 communicating with the module expansion bin 012, the front locking shell 015 is provided with an elastic buckle 0152 on an upper side wall and a lower side wall located at the opening 0151, the locking portion 023 includes a locking main body 0231, the locking main body 0231 is provided with a clamping groove 0232, and the elastic buckle 0152 is movably clamped in the clamping groove 0232; the locking portion 023 further includes a rotary handle 0233 and a sliding block 0234, the locking main body 0231 is provided with a sliding groove 0235, the sliding groove 0235 is provided below the clamping groove 0232, and the sliding groove 0235 is in communication with the clamping groove 0232; the sliding block 0234 is slidably connected in the sliding groove 0235, and a top of the sliding block 0234 is separably connected to the elastic buckle 0152; and the rotary handle 0233 is provided with a rotary portion 0236, a side wall of the rotary portion 0236 is provided with a spiral sliding protrusion 0237, the sliding block 0234 is provided with a spiral groove 0238 adapted to the sliding protrusion 0237, the rotary portion 0236 is horizontally and rotatably connected to the locking main body 0231, and the sliding protrusion 0237 is slidably connected in the spiral groove 0238.

In the present application, when the rotary handle 0233 is rotated horizontally, the spiral sliding protrusion 0237 can move relative to the spiral groove 0238. Since the rotary handle 0232 and the locking portion 023 are only connected in a horizontal rotation and are fixed in an up-and-down direction, the rotary handle 0233 does not move up and down when rotating horizontally, the sliding protrusion 0237 will force the sliding block 0234 to move up and down in the sliding groove 0235, and a top of the sliding block 0234 will disengage or bear against the elastic buckle 0152; when the top of the sliding block 0234 abuts against the elastic buckle 0152, the elastic buckle 0152 will be pushed out of the clamping groove 0232, so as to achieve the unlocking between the locking portion 023 and the front locking shell 015; and when the top of the sliding block 0234 is separated from the elastic buckle 0152, the elastic buckle 0152 is reset into the clamping groove 0232 based on its own elasticity to achieve locking between the locking portion 023 and the front locking shell 015.

Further, the energy storage and power supply unit 01 further includes a rear shell 016, the energy storage and power supply unit 01 includes a unit conductive connection sheet 017, the unit conductive connection sheet 017 passes through the rear shell 016 up and down, the unit conductive connection sheet 017 is electrically connected to the unit control board 013, one end of the unit conductive connection sheet 017 is provided with a clamping portion 0171, the other end thereof is provided with a clamping groove 0172, and the clamping portion 0171 is adapted to the clamping groove 0172. In the present application, when the energy storage and power supply units 01 of the upper and lower layers are stacked, conductive connection can be performed via the unit conductive connection sheet 017, and when connected, the unit conductive connection sheets 017 of the upper and lower layers can be clamped and fixed via the clamping groove 0172 and the clamping portion 0171, so as to ensure the stability of the conductive connection.

In the present embodiment, the unit conductive connection sheet 017 is provided in four respectively corresponding to positions of the four module expansion bins 012.

Further, a first limiting protrusion 0161 is provided on a bottom of the rear shell 016, a first limiting groove 0162 is provided on a top of the rear shell 016, the first limiting protrusion 0161 is adapted to be clamped with the first limiting groove 0162, a top of the unit conductive connection sheet 017 is provided in the first limiting groove 0162, and a bottom of the unit conductive connection sheet 017 is provided in the first limiting protrusion 0161. When the energy storage and power supply units 01 of the upper and lower layers are stacked, the first limiting protrusion 0161 can cooperate with the first limiting groove 0162 to ensure the stability of the unit conductive connection sheet 017.

Further, a second limiting protrusion 0153 is provided on a bottom of the front locking shell 015, a second limiting groove 0154 is provided on a top of the front locking shell 015, and the second limiting protrusion 0153 is adapted to be clamped with the second limiting groove 0154. When the energy storage and power supply units 01 of the upper and lower layers are stacked, the second limiting protrusion 0153 can cooperate with the second limiting groove 0154 for limiting positions to ensure the stability of the structure.

Further, a penetration hole 014 is provided on the front locking shell 015 and the rear shell 016, a positioning rod 018 is provided in the penetration hole 014, the positioning rod 018 penetrates the penetration hole 014 up and down, a threaded connection end 0181 is provided at a bottom of the positioning rod 018, an internal thread 0182 adapted to the threaded connection end 0181 is provided at a top of the positioning rod 018, and the threaded connection end 0181 is in threaded connection with the internal thread 0182. When the energy storage and power supply units 01 of the upper and lower layers are stacked, the positioning rods 018 of the upper and lower layers can achieve fixation between the energy storage and power supply units 01 of the upper and lower layers by means of a threaded connection fitting of the threaded connection end 0181 and the internal thread 0182.

Further, a knurled nut 0155 is further fixed in the penetration hole 014, and a middle portion of the positioning rod 018 is in threaded connection with the knurled nut 0155. In the present application, a thread adapted to the knurled nut is provided in the middle portion of the positioning rod 018, and the knurled nut 0155 can move above and below the positioning rod 018, but when the knurled nut moves to an easy edge of the thread, the knurled nut can be relatively fixed with the positioning rod; and when positioning rods 018 of the upper and lower layers are threadedly connected, the knurled nut 0155 can ensure the fixing of the positioning rod 018 of the lower layer and facilitate the screwing of the positioning rod 018 of the upper layer to achieve the threaded connection between the positioning rods 018 of the upper and lower layers.

Further, a heat dissipation fan 019 is further provided behind the module expansion bin 012, the heat dissipation fan 019 is electrically connected to the unit control board 013, the heat dissipation fan 019 is provided in the rear shell 016, and a heat dissipation vent hole 0163 is further provided on the rear shell 016.

The foregoing description is merely preferred embodiments of the present disclosure, and is not intended to limit the present disclosure. Any modifications, equivalents, improvements, etc. within the spirit and principles of the present disclosure are intended to be included within the scope of the present disclosure.

## Claims

1. An expandable portable multi-functional energy storage and power supply device, **characterized by** comprising one or more energy storage and power supply units, wherein adjacent energy storage and power supply units are stacked with one on top of another and are electrically connected to each other, the energy storage unit comprises a unit main body, the unit main body comprises one or more module expansion bins, a functional module is provided in the module expansion bin, the unit main body is provided with a unit control board at a position corresponding to the module expansion bin, a standard interface terminal is provided on the unit control board, a module control board is provided in the functional module, a standard interface adapted to the standard interface terminal is provided on the module control board, and the standard interface terminal is electrically connected to the standard interface.

2. The expandable portable multi-functional energy storage and power supply device according to claim 1, **characterized in that** a first anti-dead terminal group and a second anti-dead terminal group are provided on the unit control board, the first anti-dead terminal group and the second anti-dead terminal group are respectively symmetrically provided on a left side and a right side of the standard interface terminal, a first anti-dead jack group and a second anti-dead jack group corresponding to positions of the first anti-dead terminal group and the second anti-dead terminal group are provided on the module control board, and the first anti-dead terminal group and the second anti-dead jack group are respectively symmetrically provided on a left side and a right side of the standard interface; and
the first anti-dead terminal group and the second anti-dead terminal group each comprise an even number of anti-dead connection sheets, the first anti-dead jack group and the second anti-dead jack group each comprise an even number of anti-dead jacks, adjacent anti-dead connection sheets form a group of positive and negative pole connections, and adjacent anti-dead jacks form a group of positive and negative pole connections.

3. The expandable portable multi-functional energy storage and power supply device according to claim 1, **characterized in that** the energy storage and power supply unit further comprises a front locking shell, the front locking shell is connected to a front end of the module expansion bin, a front end of the functional module is provided with a locking portion, and the locking portion is movably clamped with the front locking shell.

4. The expandable portable multi-functional energy storage and power supply device according to claim 3, **characterized in that** the front locking shell is provided with an opening communicating with the module expansion bin, the front locking shell is provided with a clamping groove on a side wall located at the opening, the locking portion comprises a locking main body, a movable buckle, a return spring and a toggle piece, the locking main body is provided with a movable groove therein, the movable buckle and the return spring are both provided in the movable groove, a front end of the movable buckle penetrates through a side wall of the movable groove and is movably clamped in the clamping groove, one end of the return spring abuts against an end of the movable buckle, the other end thereof is supported on the side wall, away from the clamping groove, of the movable groove, the toggle piece is rotatably connected to the locking main body, and the toggle piece is able to drive the movable buckle to move in the movable groove toward the return spring by rotation, so that the front end of the movable buckle retracts into the movable groove.

5. The expandable portable multi-functional energy storage and power supply device according to claim 4, **characterized in that** a rotary shaft is provided on an outer side surface of the locking main body, the toggle piece is rotatably connected to the locking main body via the rotary shaft, a via hole is further provided on the outer side surface of the locking main body, a first toggle baffle is provided on an inner side of the toggle piece, a second toggle baffle is further provided on an outer side of the movable buckle, and the first toggle baffle passes through the via hole and abuts against the second toggle baffle; and
the outer side surface of the locking main body is further provided with a limiting protrusion protruding outwards, the toggle piece is provided with a toggle sheet connected to the first toggle baffle, the toggle sheet is provided with a limiting groove, and a front end of the limiting protrusion is limited in the limiting groove.

6. The expandable portable multi-functional energy storage and power supply device according to claim 3, **characterized in that** the front locking shell is provided with an opening communicating with the module expansion bin, the front locking shell is provided with an elastic buckle on a side wall located at the opening, the locking portion comprises a locking main body, the locking main body is provided with a clamping groove, and the elastic buckle is movably clamped in the clamping groove; the locking portion further comprises a rotary handle and a sliding block, the locking main body is provided with a sliding groove, the sliding groove is provided below the clamping groove, and the sliding groove is in communication with the clamping groove; the sliding block is slidably connected in the sliding groove, and a top of the sliding block is separably connected to the elastic buckle; and the rotary handle is provided with a rotary portion, a side wall of the rotary portion is provided with a spiral sliding protrusion, the sliding block is provided with a spiral groove adapted to the sliding protrusion, the rotary portion is horizontally and rotatably connected to the locking main body, and the sliding protrusion is slidably connected in the spiral groove.

7. The expandable portable multi-functional energy storage and power supply device according to claim 3, **characterized in that** a conductive post assembly is further provided in the energy storage and power supply unit, the conductive post assembly is electrically connected to the unit control board, and an upper end and a lower end of the conductive post assembly extend outside the energy storage and power supply unit.

8. The expandable portable multi-functional energy storage and power supply device according to claim 7, **characterized in that** the conductive post assembly comprises a conductive post main body, an upper movable buckle, an upper ejection spring and a lower adjustment spring, wherein the energy storage and power supply unit is further provided with a columnar groove penetrating up and down therein, a groove is provided on an outside of a top side wall of the columnar groove, a protrusion adapted to the groove is provided on an outside of a bottom side wall of the columnar groove, the upper movable buckle is movably provided in the groove, and a through hole communicating with the columnar groove is provided in both the upper movable buckle and the protrusion, the conductive post main body is provided in the columnar groove, and the upper end and the lower end of the conductive post main body respectively penetrate into the through holes of the protrusion and the upper movable buckle, a middle portion of the conductive post main body protrudes to a peripheral side to form a wiring connection post, the upper ejection spring is provided on an upper portion of the conductive post main body, an upper end of the upper ejection spring abuts against a bottom of the upper movable buckle, a lower end of the upper ejection spring abuts against an upper top surface of the wiring connection post, the lower adjustment spring is sheathed on a lower portion of the conductive post main body, an upper end of the lower adjustment spring abuts against a lower bottom surface of the wiring connection post, and a lower end of the lower adjustment spring abuts against a lower bottom surface of the columnar groove.

9. The expandable portable multi-functional energy storage and power supply device according to claim 8, **characterized in that** the conductive post assembly further comprises a limiting buckle, a limiting clamping groove is provided on the wiring connection post, a limiting mounting groove is provided on a side wall of the columnar groove, two sides of the limiting buckle are fixed in the limiting mounting groove, and a middle portion of the limiting buckle is clamped in the limiting clamping groove and is able to move up and down in the limiting clamping groove.

10. The expandable portable multi-functional energy storage and power supply device according to claim 8, **characterized in that** the energy storage and power supply unit further comprises a rear shell, the conductive post assemblies are provided in four groups, the rear shell and the front locking shell are both provided with two columnar grooves in parallel from left to right, the two columnar grooves on the front locking shell are located directly in front of the two columnar grooves on the rear shell, the four groups of conductive post assemblies are respectively provided in the four columnar grooves, two first connecting flexible wires are provided in the unit main body, two second connecting flexible wires are further provided in the rear shell, a front end of the first connecting flexible wire is electrically connected to the conductive post main body in the front locking shell, a rear end of the first connecting flexible wire is connected to a first electrical connection block, the first electrical connection block is electrically connected to the unit control board, a rear end of the second connecting flexible wire is electrically connected to the conductive post main body in the rear shell, a front end of the second connecting flexible wire is connected to a second electrical connection block, and the second electrical connection block is electrically connected to the unit control board;
the rear end of the first connecting flexible wire is further sheathed with a first locking ring, a first locking screw is threaded on the first locking ring, and the first electrical connection block and the rear end of the first connecting flexible wire are both provided in the first locking ring and are locked by the first locking screw; and
the rear end of the second connecting flexible wire is further sheathed with a second locking ring, a second locking screw is threaded on the second locking ring, and the second electrical connection block and the rear end of the second connecting flexible wire are both provided in the second locking ring and are locked by the second locking screw.

11. The expandable portable multi-functional energy storage and power supply device according to claim 7, **characterized in that** a top of the energy storage and power supply unit is further provided with a power generation control module, wherein the power generation control module comprises a housing and an electric control assembly, the electric control assembly is provided in the housing, the electric control assembly comprises a power generation control board, an electrical connection sheet and a power generation connection post, the power generation connection posts are provided in four, the housing is provided with four connection holes corresponding to positions of the conductive post assemblies of the energy storage and power supply unit, and the four power generation connection posts are respectively mounted in the four connection holes to be electrically connected to the conductive post assemblies, the electrical connection sheets are provided in two, four power generation connection posts are cross-connected via two electrical connection sheets, the electrical connection sheets are electrically connected to the power generation control board, and the power generation control board is further provided with a standard power supply interface with one end exposed.

12. The expandable portable multi-functional energy storage and power supply device according to claim 1, **characterized in that** the energy storage and power supply unit further comprises a rear shell, the energy storage and power supply unit comprises a unit conductive connection sheet, the unit conductive connection sheet penetrates the rear shell up and down, the unit conductive connection sheet is electrically connected to the unit control board, one end of the unit conductive connection sheet is provided with a clamping portion, the other end thereof is provided with a clamping groove, and the clamping portion is adapted to the clamping groove.
